# EUROPEAN PATENT SPECIFICATION

(11) **EP 3 185 289 B1**
(45) Date of publication and mention of the grant of the patent: **20.01.2021**
(21) Application number: 15307132.9
(22) Date of filing: 23.12.2015
(51) Int. Cl.: H01L 23/38, F04B 19/24, F04B 43/04, H01L 23/473

(54) **COOLING WITH THERMOELECTRIC FLUID PUMP**
KÜHLSYSTEM MIT THERMOELEKTRISCHER FLUIDISCHER PUMPE
SYSTÈME DE REFROIDISSEMENT AVEC POMPE FLUIDIQUE THERMOÉLECTRIQUE

(43) Date of publication of application: 28.06.2017
(73) Proprietor: Alcatel Lucent, 91620 Nozay (FR)
(72) Inventor: JEFFERS, Nicholas, DUBLIN, 15 (IE); STAFFORD, Jason, DUBLIN, 15 (IE); DONNELLY, Brian, DUBLIN, 15 (IE)
(74) Representative: Nokia EPO representatives

(56) References cited:
- EP-A1- 2 500 957
- WO-A1-2005/071748
- US-A- 2 910 836
- US-A1- 2006 078 434
- US-A1- 2011 020 140

## Description

The present invention relates to cooling systems and methods of cooling using a fluid.

### BACKGROUND

The recent significant growth in data traffic in telecommunications requires more functionality from future electronic or photonics packages. More functionality implies comparatively higher levels of heat generation. The current thermal solutions employed today do not appear to be capable of scaling sufficiently to meet future network demands. One approach for cooling such components is based on using fluidic pumps. Prior art publications WO 2005/071748, US 2006/078434 and US 2011/020140 disclose fluidic pumps.

### SUMMARY

Some embodiments feature an apparatus comprising:
- a thermoelectric cooler;
- a fluid;
- a first chamber and a second chamber connected to one another through a channel;
- the thermoelectric cooler being configured to be electrically powered to heat the fluid in the first chamber to cause the fluid to flow through the channel, from the first chamber towards the second chamber and to make thermal contact with a heat source to absorb heat from the heat source;
wherein, the apparatus further comprises a control circuit configured to:
- switch off the electric power applied to the thermoelectric cooler;
- measure a parameter indicative of electric power generated by the thermoelectric cooler; and
- vary a flow rate of the fluid based on the measurement of said parameter obtained from the thermoelectric cooler.

According to some specific embodiments, the control circuit comprises circuitry configured to measure the power generated by the thermoelectric cooler in switched off mode, based on said parameter.

According to some specific embodiments, the control circuit comprises circuitry configured to assess the measurement of said parameter in switched off mode and determine whether the measured parameter is indicative of an optimal operating condition by comparing the measured parameter with a predetermined value or a predetermined range of values.

According to some specific embodiments, the control circuit is configured to vary the flow rate of the fluid by determining a polarity of the measured parameter. According to some specific embodiments, the control circuit is configured to vary said flow rate to a lower rate for a first polarity of the measured parameter. According to some specific embodiments, the control circuit is configured to vary said flow rate to a higher rate for a second polarity of the measured parameter opposite to the first polarity.

According to some specific embodiments, the apparatus is configured to:
- apply a first polarity of electric power to the thermoelectric cooler to thereby heat the fluid in the first chamber and cause it flow through the channel;
- apply a second polarity of electric power opposite to the first polarity to the thermoelectric cooler to thereby heat the fluid in the second chamber and cause it flow through the channel;
wherein a direction of flow of the fluid caused by the first polarity is the same as the direction of flow of the fluid caused by the second polarity.

According to some specific embodiments, the parameter is indicative of electric power is a voltage present between two points, each point located on a respective side of the thermoelectric cooler; or an electric current flowing between said two points.

Some embodiments feature a method comprising:
- powering a thermoelectric cooler to heat a fluid in a first chamber to cause the fluid to flow through a channel, from the first chamber towards a second chamber and to make thermal contact with a heat source to absorb heat from the heat source;
- switching off the electric power applied to the thermoelectric cooler;
- measuring a parameter indicative of electric power generated by the thermoelectric cooler; and
- varying a flow rate of the fluid based on the measurement of the parameter obtained from the thermoelectric cooler.

According to some specific embodiments, the method further comprises:
- assessing the measurement of said parameter in switched off mode;
- comparing the measured parameter with a predetermined value or a predetermined range of values; and
- determining whether the measured parameter is indicative of an optimal operating condition.

According to some specific embodiments, the method further comprises determining a polarity of the measured parameter to vary the flow rate of the fluid.

According to some specific embodiments, the method further comprises varying said flow rate to a lower rate for a first polarity of the measured parameter. According to some specific embodiments, the method further comprises varying said flow rate to a higher rate for a second polarity of the measured parameter opposite to the first polarity.

According to some specific embodiments, the method further comprises:
- applying a first polarity of electric power to the thermoelectric cooler to thereby heat the fluid in the first chamber and cause it flow through the channel;
- applying a second polarity of electric power opposite to the first polarity to the thermoelectric cooler to thereby heat the fluid in the second chamber and cause it flow through the channel;
wherein a direction of flow of the fluid caused by the first polarity is the same as the direction of flow of the fluid caused by the second polarity.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figures 1 is an exemplary schematic representation of a heat transfer assembly comprising a pump according to some embodiments.
Figures 2A-2D, collectively figure 2, are exemplary schematic representations of various phases of operation of the pump of Figure 1 under optimal condition.
Figures 3A-3D, collectively figure 3, are exemplary schematic representations of various phases of operation of the pump of Figure 1 under a condition where the fluid inlet to the pump has a temperature which is cooler than optimal.
Figures 4A-4D, collectively figure 4, are exemplary schematic representations of various phases of operation of the pump of Figure 1 under a condition where the fluid inlet to the pump has a temperature which is hotter than optimal.

### DETAILED DESCRIPTION

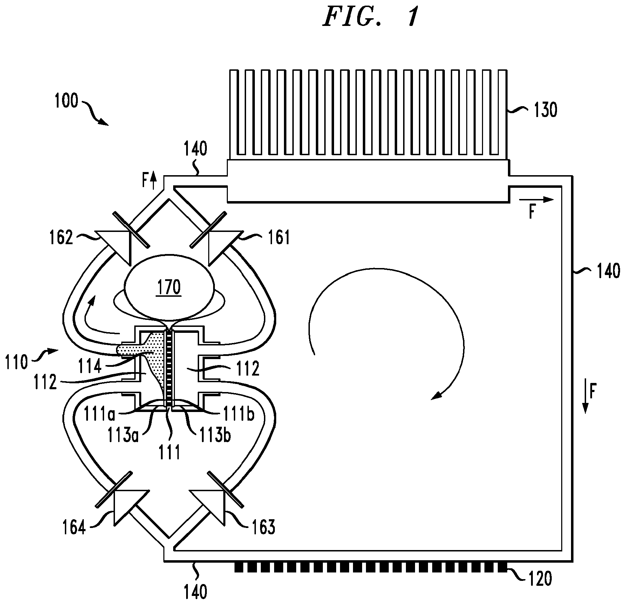

Referring to figure 1, there is shown a heat transfer assembly comprising a fluidic pump (herein also referred to as pump) according to some embodiments of the disclosure. Except for the differences mentioned further below, this heat transfer assembly has substantial similarities in structure and operation with a pump described in the European patent application number 14306808.8 filed on 14 November 2014.

Referring back to figure 1 the heat transfer assembly 100 comprises a pump 110 a heat source 120 such as an optical or electronic component to be cooled and a thermal energy removal mechanism 130 such as a heat sink.

The pump 110 comprises a first chamber 113a and a second chamber 113b.

A working fluid 112 is used for heat transfer operations. The working fluid 112 is provided inside the first chamber 113a and the second chamber 113b and is capable of flowing from one chamber to the other through one or more channels 140.

The channels 140 may be the so-called micro-channels which have at least one cross-sectional dimension below 1mm in length. Alternatively they may be channels with larger cross-sectional dimensions. Herein, any reference to a channel is to be understood to refer to both such options.

Although in the figure the heat source 120 is shown to be adjacent to the microchannel 140 and not submerged into the working fluid, the disclosure is not so limited and some embodiments may provide for submerging the heat source 120 inside a region where the working fluid flows, for example inside the cooling chamber 150.

The heat transfer assembly 100 further comprises a TEC 111 provided within the pump 110. A TEC, i.e. Thermoelectric Cooler, is a known solid-state device typically used as heat pump that is capable of pumping heat from one side to the other in response to a supplied voltage. The direction of pumping the heat depends on the polarity of the supplied voltage. If the voltage applied to the TEC is reversed, the direction of the heat pumping effect will also be reversed. Under normal conditions, this heat transfer results in one side of the TEC being above and the other side being below the ambient temperature. By normal condition it is meant to refer to a condition in which the TEC surface temperature is within ±10°C from the temperature of the working fluid.

A cooling chamber 150 may also be provided to enhance heat transfer from the working fluid to the thermal energy removal mechanism 130.

A plurality of directional valves, 161-164, are provided to ensure a one-directional flow path as will be described below.

In operation, when a voltage is applied to the TEC 111, one side of the TEC (e.g. 111a as shown in the figure) heats up thereby increasing the pressure inside the boundaries of the corresponding chamber 113a where the fluid 112 is contained. In some embodiments, such as the example shown in figure 1, the pump is multi-phase therefore the heating of the one side of the TEC may generate vapor in the form of one or more bubbles 114. In this case the formation and growth of a bubble may be compared to a diaphragm which can extend inside the boundaries of the corresponding chamber, e.g. the left hand side of the pump in figure 1, thereby pushing the fluid out of the first chamber 113a.

In some embodiments (not explicitly shown) the pump 100 is not multi-phase therefore the heating of the one side of the TEC may simply cause thermal expansion in the fluid which is sufficient to push the fluid out of the first chamber 113a.

Referring back to figure 1, when e.g. side 111a of the TEC 111 is heated, fluid 112 is made to move out of the first chamber 113a (left hand side in the figure). At the same time, side 111b of the TEC 111 is cooled causing the fluid to move into the second chamber 113b (right hand side in the figures).

However while the one-directional valve 162 allows the fluid to flow out of the first chamber 113a, the valve 164 blocks the flow of the fluid in the opposite direction. Therefore the fluid flows in one direction out of valve 162 (e.g. upward in the figures).

As the voltage applied to the TEC 111 is reversed, the opposite side 111b of the TEC is heated up and therefore the fluid is made to move out of the second chamber 113b (right hand side in the figure). At the same time, side 111a of the TEC 111 is cooled and fluid is condensed thus causing the fluid to move into the first chamber 113a (left hand side in the figure).

However while the one-directional valve 161 allows the fluid to flow out of the second chamber 113b, the valve 163 blocks the flow of the fluid in the opposite direction. Therefore the fluid flows in one direction out of valve 161 (e.g. upward in the figure) which is the same direction as in the previous case.

Therefore, for either one of the voltage polarities applied to the TEC 111, the fluid is made to move in one direction out of the pump which is shown by arrows F in figure 1.

It is to be noted that when chamber 113a contains hot fluid, it is pressurized thus pushing fluid out (as mentioned above). This effect will also push the one-directional valve 164 to remain closed. At the same time chamber 113b is cooled down and therefore has a reduced pressure therein. This effect will open the one-directional valve 163 and pull the fluid into the chamber 113b.

The directional, or one-way, valves may be active valves (e.g. known check valves with moving parts) or passive valves (e.g. nozzles/diffusers that have no moving parts). Active valves have greater fluidic performance however they have reliability concerns due to said moving part; while passive valves have poorer fluidic performance however they have higher reliability. The choice of the valves may therefore be made in accordance to the practical requirements of each application.

The above fluidic pump has many advantages over the known cooling systems. The current generation of these pumps has a small size (e.g. 9mmX9mmX3mm which means nearly 10 times smaller than conventional pumps) and can achieve flow rates of up to 20ml/min and maximum pressures of up to 20kPa which may be considered as very good performance factors. Furthermore, as these pumps may be based on solid state technologies with no moving parts they may likely be very reliable.

However, the inventors have recognized that the performance of such fluidic pumps may be affected by ambient temperature variations. For example, with certain fluidic pumps a 10°C ambient temperature change may negatively affect such performance and thereby deteriorate the cooling efficiency.

By "ambient temperature" it is meant to refer to the temperature surrounding the pump. Although it may not always be the case, but typically such surroundings may be inside a cabinet or any similar housing in which the pumps operates.

It is therefore desired to provide a control mechanism to keep the pump operating optimally and, as much as possible, independently from room temperature.

The present disclosure addresses the above considerations. Accordingly a novel cooling architecture is proposed comprising a fluidic pump as described above and an additional mechanism to control the operation of the pump to ensure optimal performance as described in further detail below.

The present disclosure takes advantage of the fact that power is generated from a Thermoelectric Cooler (TEC) when a temperature difference exists between two sides of the same. This feature of a TEC is used in order to effectively monitor the temperature of the fluid entering the pump. The temperature is used as a feedback in order to control the pump flow rate.

Basically there is fundamentally little difference between a TEC and a Thermoelectric Generator (TEG). The main difference between these two elements is how they are deployed, i.e. typically the TEC is used for cooling purposes while the TEG is used to generate power. In other words, a TEC generates a temperature difference at its sides in response to receiving an electrical excitation at respective points on each side (e.g. using electrodes) and a TEG generates electricity at respective points on each side in response to experiencing a temperature difference between said sides. Thus the same device could be used for one or the other purpose depending on how it is deployed. In the forgoing reference will be made to TEC, however it is to be understood that at certain phases of operation the TEC may be operating as a TEG as mentioned above.

Referring back to the fluidic pump 100 of figure 1, it may therefore be understood that if there is a difference in temperature between side 111a and 111b, and the electric voltage is disconnected from the TEC 111, a voltage difference will be present between the sides 111a and 111b which can be measured by known means.

In order to ensure optimum operation, little difference in temperature should exist between the hot and the cold side of the TEC in the fluidic pump, because the pump is constantly cycling between expanding and condensing the working fluid as described above. During this process the temperature remains fixed because the cooling and heating energy from the TEC is consumed by the latent heat of expansion and condensation.

Therefore under satisfactory (or optimal) conditions, where the temperature difference between the two side of the TEC is low, minimal power is generated if the electric power to the TEC is switched off for a fraction of a second and the power generated is measured. Conversely, higher temperature differences between the sides of the TEC would result in higher power generated. The voltage generated by the TEC 111 is directly proportional to the power generated thus only voltage may be monitored. Current is also proportional to the power generated and the control circuit could likewise be configured for to measure current.

Referring back to figure 1, pump 100 a control circuit 170 is shown. The control circuit may include circuitry for measuring voltage. However, as mentioned above the current may be measure instead.

Due to the possibility of variation in the temperature of the two sides of the TEC, either a positive voltage or a negative voltage may be generated. If a positive voltage is generated then it may be determined that the inlet fluid temperature is too cool possibly caused by a reduction ambient temperature. Likewise, if a negative voltage is generated then it may be determined that the fluid entering into the pump is too hot possibly caused by an increase ambient temperature. The control circuit 170 may be configured to take actions to increase or decrease the flow rate in the pump thus controlling the temperature at which the fluid leaves the cooling chamber and consequently the fluid temperature that is recycled back into the pump. This mechanism can therefore ensure that the fluid inlet temperature into the pump is maintained constant, or at least within an acceptable fluctuation range, regardless of ambient temperature fluctuations.

For example, if the pump fluid 112 is configured to change phase in an ambient temperature of 55°C (which is the standard required by Network Equipment Building Systems, i.e. NEBS) and the actual ambient temperature fluctuates between 40°C (winter) and 55°C (summer) then it will be more difficult for the TEC 111 in the pump to heat the fluid to cause efficient thermal expansion therein in such a cooler ambient because a substantial amount of thermal energy from the TEC 111 will be consumed by sensible heating (sensible heating results in an increase in fluid temperature without a change in phase). Therefore the control circuit may operate to maintain constant, or with minimal fluctuation, the fluid inlet temperature into the pump, regardless of the external ambient temperature. This may be achieved by increasing and decreasing the flow rate in the loop which in turn increases and decreases the time that the fluid spends in contact with the heat source 120.

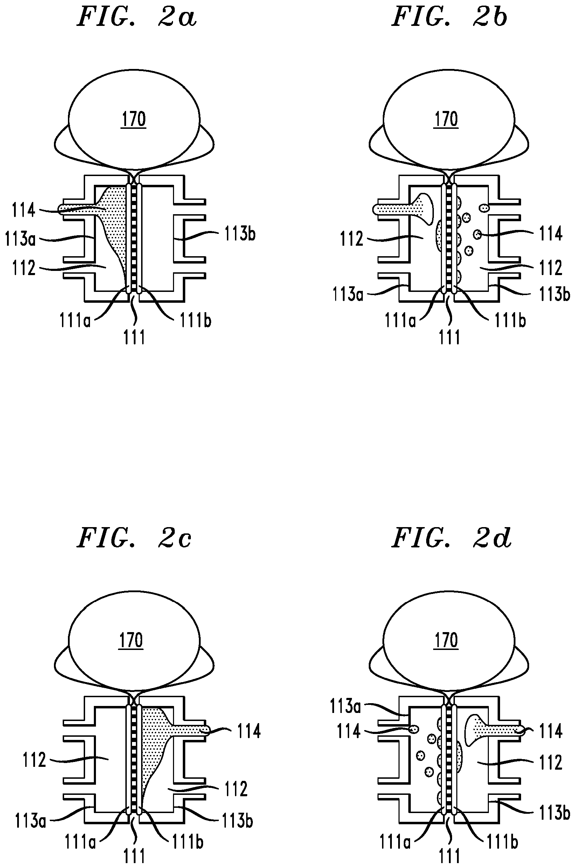

This operation is described below with reference to figures 2, 3 and 4. In these figures like elements have been provided with like reference numerals as those of figure 1.

Figures 2a-2d show various phases of an optimal operation of an exemplary pomp 100 as described with reference to figure 1.

Figure 2a shows an initial phase, say at time zero, in which side 111a of the TEC 111 heats the fluid 112 thereby causing the fluid to flow out of chamber 113a, e.g. by generating bubbles 114 as shown in the figure. Side 111b of the TEC 111 is cooler and thus fluid flows inside chamber 113b. It is assumed that the inlet temperature of the fluid in chamber 113b is 54.4°C.

Herein, the term inlet fluid temperature is meant to refer to the temperature of the fluid entering a chamber which is being cooled and outlet fluid temperature is meant to refer to the temperature of the fluid leaving a chamber which is being heated.

Figure 2b shows a second phase, say at 0.5 second from the first phase, in which the polarity of the electric voltage (or current) applied to the TEC is reversed. Therefore, side 111b of the TEC 111 heats the fluid 112 which would eventually cause thermal expansion in the fluid (with or without bubbles 114). Side 111a of the TEC 111 cools down.

At a certain point during this second phase, for example at the start of the fluid phase change, the electric power applied to the TEC 111 is switched off and a voltage measurement is performed by the control circuit 170. The measurement may take a relatively short time for example 0.05 sec. It is again assumed that the inlet temperature of the fluid in chamber 113a is 54.4°C and the outlet temperature of the fluid in chamber 111b is 55°C.

The control circuit then determines whether the measured voltage (which is proportional to the electric power) is indicative of an optimal operating condition by comparing the measured voltage (or the related power) with a predetermined value or a predetermined range of values. For example, the predetermined value may be 2V. Therefore if the measured voltage is any value having a magnitude (i.e. either positive or negative) lower than this predetermined value it is determined that the optimal conditions of operation are present. Otherwise, it is determined that optimal conditions are not present.

In the present example, as the temperature difference between the fluids in the two chambers is relatively low, i.e. only 0.5°C, the voltage measured at output terminals of the TEC would also be low, for example lower than 1V. This low voltage is therefore indicative of optimal operation of the pump 100.

Although in the examples provided herein it is mentioned that the control circuit measures voltage, the disclosure is not so limited and the control circuit may likewise be configured to measure a current flowing through the two measurement points. As the voltage and the current are both proportional to the electric power generated by the TEC in the switched off mode, they may be collectively referred to as parameters indicative of electric power.

Figures 2c and 2d show subsequent phases, say at 1 second and 1.5 seconds after the first phase respectively. As can be seen in figure 2c, the operation is similar to that of the initial phase of figure 2a but with an opposite polarity.

Therefore fluid is caused to flow out of chamber 113b. Figure 2d, shows once more a reversal of the polarity of the voltage applied to the TEC with consequences similar to those of figure 2b but with an opposite polarity. At this stage it is not needed to turn the power off for another measurement; however this possibility is not excluded. Similar temperature differences as those mentioned with reference to figures 2a and 2b may also be considered in the fluid of the two chambers for these phases.

However, if the ambient temperature drops (e.g. to 40°C), it will have the effect of cooling the fluid 112 more at the cooling chamber 150 (figure 1). Therefore the inlet fluid temperature entering the pump 100 becomes too cool and requires a substantial amount of sensible heating before the fluid expands. This hampers the performance of the pump and in extreme circumstances could cause the pump to stop pumping, leading to component failure.

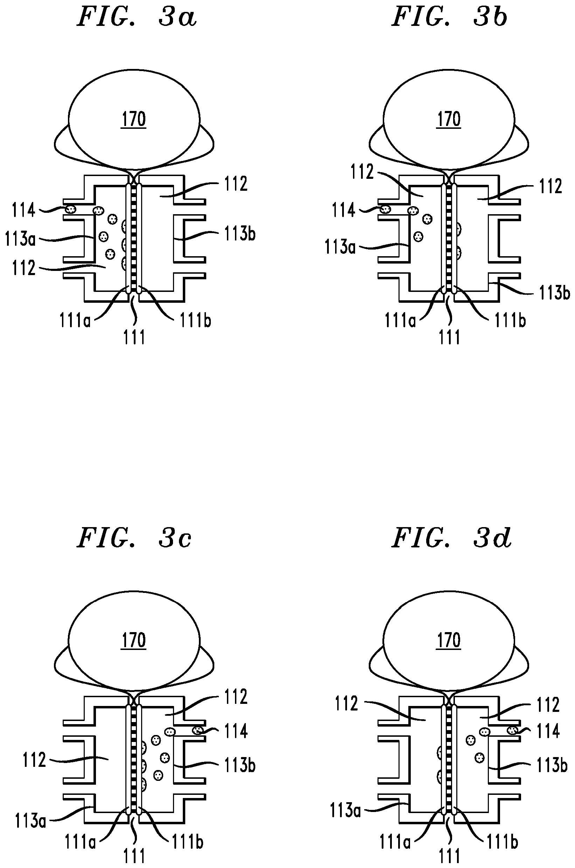

Figures 3a-3d show various phases of operation of the exemplary pump 100 of figure 1 under conditions in which the inlet fluid temperature is too cool.

In the context of the present disclosure when the temperature of the inlet fluid is 5°C or more lower than the temperature of the outlet fluid it may be considered that the inlet temperature is too cool.

Figure 3a shows an initial phase, say at time zero, in which side 111a of the TEC 111 heats the fluid 112, thereby causing the fluid to heat up and thermally expand (with or without generating bubbles 114). However the inlet flow temperature within side 111b of the TEC 111 is too cool, in this example 45°C. Therefore, the operation of the pump is not optimal.

Figure 3b shows a second phase, say at 0.5 second from the first phase, in which the polarity of the electric voltage (or current) applied to the TEC is reversed. Therefore, side 111b of the TEC 111 heats the fluid 112 while side 111a of the TEC 111 cools down. At a certain point during this second phase, for example at the start of the phase, the electric power applied to the TEC 111 is switched off and a voltage measurement is performed by the control circuit 170. Similar to the description of figure 2b, here also the measurement may take a relatively short time for example 0.05 sec. In this case however, the inlet temperature of the fluid in chamber 113a is too cool, e.g. 44°C as compared to the outlet temperature of the fluid in chamber 111b e.g. 54°C.

As the temperature difference between the fluids in the two chambers is relatively high, i.e. 10°C, the voltage measured at output terminals of the TEC would also be high. Therefore the voltage generated is greater than the voltage at optimal conditions. Assuming that a positive voltage is generated, the control circuit 170 may include preprogrammed circuitry configured to determine that such positive voltage is indicative of a drop in the inlet fluid temperature. The control circuit 170 may further be programmed to take action to slow down the flow rate in the pump. For example the control circuit may take action to increase the off time of the TEC 111 to more than 0.05 second to thereby reduce the flow rate of the fluid 112 through the pump 100. This causes the fluid to stay a longer period of time in thermal contact (directly or indirectly) with the heat source 120 resulting in an increase in the inlet fluid temperature, thus returning the pump 100 to the optimal state of operation as described with reference to figure 2.

Figures 3c and 3d show subsequent phases, say at 1 second and 1.5 second after the first phase respectively. As can be seen in figure 3c, the operation is similar to that of the initial phase of figure 3a but with an opposite polarity. Therefore fluid is heated in chamber 113b. Figure 3d, shows once more a reversal of the polarity of the voltage applied to the TEC with consequences similar to those of figure 3b but with an opposite polarity. At this stage it is not needed to turn the power off for another measurement; however this possibility is not excluded.

Alternatively the inlet fluid temperature may become too hot due to an increase in the ambient temperature.

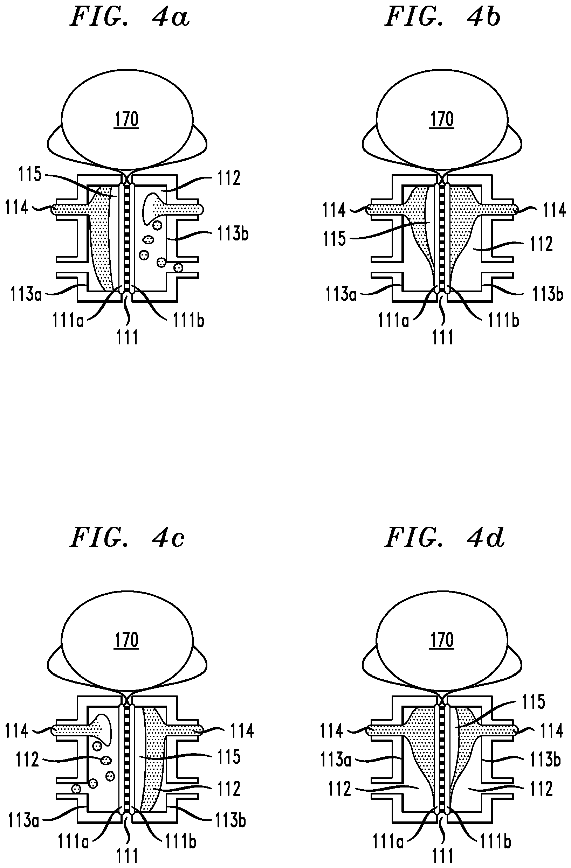

Figures 4a-4d show various phases of operation of the exemplary pump 100 of figure 1 under conditions in which the inlet fluid temperature is too hot.

In the context of the present disclosure when the temperature of the inlet fluid is 10°C or more higher than the temperature of the outlet fluid it may be considered that the inlet fluid temperature is too hot.

Figure 4a shows an initial phase, say at time zero, in which side 111a of the TEC 111 heats the fluid 112, thereby causing the fluid to heat up and thermally expand. However the inlet flow temperature within side 111b of the TEC 111 is too hot, in this example above 55°C. Therefore, the operation of the pump is not optimal. Furthermore, as the temperature of the fluid in chamber 113a become very hot (due to the combined effect of the high ambient temperature and the TEC heating action), a dry out bubble 115 may be formed which may hamper an efficient exchange of heat between the side 111a and the fluid in chamber 113a. Figure 4b shows a second phase, say at 0.5 second from the first phase, in which the polarity of the electric voltage (or current) applied to the TEC is changed. Therefore, side 111b of the TEC 111 heats the fluid 112 while side 111a of the TEC 111 cools down. However the temperature at the inlet side, in this case chamber 113a, is still high. Furthermore, the generation of the dry out bubble 115 impedes an efficient heat transfer between the fluid and the cooling side 111a thereby hampering the reduction of temperature of the fluid in this chamber. This is because when a dry out occurs on the TEC surface during the heating phase on that surface the temperature rapidly increases far beyond the phase change temperature of the fluid. Therefore when the cooling cycle of that same surface begins the TEC is required to cool such excessive heat therefore hampering its performance.

At a certain point during this second phase, for example at the start of the phase, the electric power applied to the TEC 111 is switched off and a voltage measurement is performed by the control circuit 170. The measurement may take a relatively short time for example 0.05 sec. In this case however, the inlet temperature of the fluid in chamber 113a is too high, e.g. 65°C as compared to the outlet temperature of the fluid in chamber 111b e.g. 55°C.

As the temperature difference between the fluids in the two chambers is relatively high, i.e. 10°C, the voltage measured at output terminals of the TEC would also be high. Therefore the voltage generated is greater than the voltage in an optimal condition. Assuming that a negative voltage is generated, the control circuit 170 may be preprogrammed to determine that such negative voltage is indicative of an increase in the inlet fluid temperature. The control circuit 170 may further be programmed to take action to speed up the flow rate in the pump. For example the control circuit 170 may take action to decrease the off time of the TEC 111 to lower than 0.05 second to thereby increase the flow rate of the fluid 112 through the pump 100. This causes the fluid to stay a shorter period of time in contact (directly or indirectly) with the heat source 120 resulting in the inlet fluid temperature to decrease, thus returning the pump 100 to the optimal state of operation as described with reference to figure 2.

Figures 4c and 4d show subsequent phases, say at 1 second and 1.5 second after the first phase respectively. As can be seen in figure 4c, the operation is similar to that of the initial phase of figure 4a but with an opposite polarity. Therefore fluid is heated in chamber 113b. Figure 4d, shows once more a reversal of the polarity of the voltage applied to the TEC with consequences similar to those of figure 4b but with an opposite polarity.

In this manner, it becomes possible to deploy a fluidic pump in an environment with a fluctuating ambient temperature without compromising the performance of the pump. The proposed solution allows for designing equipment in compliance with the stringent requirements of the NEBS standard which at times become difficult to achieve. The control circuit can be used to ensure that the pump is optimized to operate under harsh conditions.

The control circuit can be any of hardware devices, software modules or combination of hardware devices and software modules known in the related art. The control circuit may include circuitry for measuring voltage and/or current and for assessing the measurements and taking appropriate actions as described above. Such circuitry may include known means such as an Application Specific Integrated Circuit (ASIC), a Field Programmable Gate Array (FPGA) and/or a microprocessor, and in a preferred embodiment through or together with a suitable software program may be used.

Further it is to be noted that the list of structures corresponding to the claimed means is not exhaustive and that one skilled in the art understands that equivalent structures can be substituted for the recited structure without departing from the scope of the disclosure.

It should be appreciated by those skilled in the art that any block diagrams herein represent conceptual views of illustrative circuitry embodying the principles of the disclosure.

## Claims

1. An apparatus comprising:
- a thermoelectric cooler (111);
- a fluid (112);
- a first chamber (113A) and a second chamber (113B) connected to one another through a channel (140);
- the thermoelectric cooler being configured to be electrically powered to heat the fluid (112) in the first chamber (113A) to cause the fluid (112) to flow through the channel (140), from the first chamber (113A) towards the second chamber (113B) and to make thermal contact with a heat source (120) to absorb heat from the heat source (120);
wherein, the apparatus further comprises a control circuit (170) configured to:
- switch off the electric power applied to the thermoelectric cooler (111);
- measure a parameter indicative of electric power generated by the thermoelectric cooler (111); and
- vary a flow rate of the fluid (112) based on the measurement of said parameter obtained from the thermoelectric cooler (111).

2. The apparatus of claim 1, wherein, the control circuit comprises circuitry configured to measure the power generated by the thermoelectric cooler in switched off mode, based on said parameter.

3. The apparatus of claim 1 or claim 2, wherein the control circuit comprises circuitry configured to assess the measurement of said parameter in switched off mode and determine whether the measured parameter is indicative of an optimal operating condition by comparing the measured parameter with a predetermined value or a predetermined range of values.

4. The apparatus of any one of the preceding claims, wherein the control circuit is configured to vary the flow rate of the fluid by determining a polarity of the measured parameter.

5. The apparatus of claim 4, wherein the control circuit is configured to vary said flow rate to a lower rate for a first polarity of the measured parameter.

6. The apparatus of claim 5, wherein the control circuit is configured to vary said flow rate to a higher rate for a second polarity of the measured parameter opposite to the first polarity.

7. The apparatus of any one of the preceding claims, wherein the apparatus is configured to:
- apply a first polarity of electric power to the thermoelectric cooler to thereby heat the fluid in the first chamber and cause it flow through the channel;
- apply a second polarity of electric power opposite to the first polarity to the thermoelectric cooler to thereby heat the fluid in the second chamber and cause it flow through the channel;
wherein a direction of flow of the fluid caused by the first polarity is the same as the direction of flow of the fluid caused by the second polarity.

8. The apparatus of any one of the preceding claims, wherein the parameter indicative of electric power is a voltage present between two points, each point located on a respective side of the thermoelectric cooler; or an electric current flowing between said two points.

9. A method comprising:
- powering a thermoelectric cooler (111) to heat a fluid (112) in a first chamber (113A) to cause the fluid (112) to flow through a channel (111), from the first chamber (113A) towards a second chamber (113B) and to make thermal contact with a heat source (120) to absorb heat from the heat source (120);
- switching off the electric power applied to the thermoelectric cooler (111);
- measuring a parameter indicative of electric power generated by the thermoelectric cooler; and
- varying a flow rate of the fluid (112) based on the measurement of the parameter obtained from the thermoelectric cooler.

10. The method of claim 9 further comprising:
- assessing the measurement of said parameter in switched off mode;
- comparing the measured parameter with a predetermined value or a predetermined range of values; and
- determining whether the measured parameter is indicative of an optimal operating condition.

11. The method of claim 9 or claim 10, further comprising determining a polarity of the measured parameter to vary the flow rate of the fluid.

12. The method of claim 11, comprising varying said flow rate to a lower rate for a first polarity of the measured parameter.

13. The method of claim 12, comprising varying said flow rate to a higher rate for a second polarity of the measured parameter opposite to the first polarity.

14. The method of any one of the preceding claims 9-13, comprising:
- applying a first polarity of electric power to the thermoelectric cooler to thereby heat the fluid in the first chamber and cause it flow through the channel;
- applying a second polarity of electric power opposite to the first polarity to the thermoelectric cooler to thereby heat the fluid in the second chamber and cause it flow through the channel;
wherein a direction of flow of the fluid caused by the first polarity is the same as the direction of flow of the fluid caused by the second polarity.

15. The method of any one of the preceding claims 9 to 14, wherein the parameter indicative of electric power is a voltage present between two points, each point located on a respective side of the thermoelectric cooler; or an electric current flowing between said two points.

## Patentansprüche

1. Vorrichtung, umfassend:
- einen thermoelektrischen Kühler (111);
- eine Flüssigkeit (112);
- eine erste Kammer (113A) und eine zweite Kammer (113B), die durch einen Kanal (140) miteinander verbunden sind;
- wobei der thermoelektrische Kühler so konfiguriert ist, dass er elektrisch betrieben wird, damit die Flüssigkeit (112) in der ersten Kammer (113A) erhitzt und veranlasst wird, dass die Flüssigkeit (112) von der ersten Kammer (113A) in Richtung der zweiten Kammer (113B) durch den Kanal (140) fließt und in thermischen Kontakt mit einer Wärmequelle (120) kommt, um Wärme von der Wärmequelle (120) zu absorbieren;
wobei die Vorrichtung ferner einen Regelkreis (170) umfasst, der so konfiguriert ist, dass er:
- den am thermoelektrischen Kühler (111) anliegenden Strom abschaltet;
- einen Parameter misst, der den angezeigten vom thermoelektrischen Kühler (111) erzeugten Strom misst; und
- eine Flussrate der Flüssigkeit (112) basierend auf der Messung dieses aus dem thermoelektrischen Kühler (111) erhaltenen Parameters variiert.

2. Vorrichtung nach Anspruch 1, wobei der Regelkreis eine Schaltung umfasst, die so konfiguriert ist, dass sie den vom thermoelektrischen Kühler erzeugten Strom in abgeschaltetem Modus basierend auf diesem Parameter misst.

3. Vorrichtung nach Anspruch 1 oder Anspruch 2, wobei der Regelkreis eine Schaltung umfasst, die so konfiguriert ist, dass sie die Messung des Parameters im abgeschalteten Modus bewertet und bestimmt, ob der gemessene Parameter auf einen optimalen Betriebszustand hinweist, indem sie den gemessenen Parameter mit einem vorgegebenen Wert oder einem vorbestimmten Wertebereich vergleicht.

4. Vorrichtung nach einem der vorstehenden Ansprüche, wobei der Regelkreis so konfiguriert ist, dass er die Flussrate der Flüssigkeit durch Bestimmung einer Polung des gemessenen Parameters variiert.

5. Vorrichtung nach Anspruch 4, wobei der Regelkreis so konfiguriert ist, dass er diese Flussrate für eine erste Polung des gemessenen Parameters auf eine niedrigere Rate variiert.

6. Vorrichtung nach Anspruch 5, wobei der Regelkreis so konfiguriert ist, dass er diese Flussrate für eine zweite Polung des gemessenen Parameters entgegengesetzt zur ersten Polung auf eine höhere Rate variiert.

7. Vorrichtung nach einem der vorstehenden Ansprüche, wobei die Vorrichtung so konfiguriert ist, dass sie:
- eine erste Polung des Stroms an den thermoelektrischen Kühler anlegt, damit die Flüssigkeit in der ersten Kammer erwärmt wird und durch den Kanal fließt;
- eine zweite Polung des Stroms entgegengesetzt zur ersten Polung an den thermoelektrischen Kühler anlegt, damit die Flüssigkeit in der zweiten Kammer erwärmt wird und durch den Kanal fließt;
wobei eine durch die erste Polung verursachte Strömungsrichtung der Flüssigkeit die gleiche ist wie die durch die zweite Polung verursachte Strömungsrichtung.

8. Vorrichtung nach einem der vorstehenden Ansprüche, wobei der den Strom anzeigende Parameter eine Spannung ist, die zwischen zwei Punkten anliegt, wobei jeder Punkt auf einer jeweiligen Seite des thermoelektrischen Kühlers angeordnet ist; oder ein elektrischer Strom, der zwischen diesen beiden Punkten fließt.

9. Verfahren umfassend:
- Betreiben eines thermoelektrischen Kühlers (111), damit eine Flüssigkeit (112) in einer ersten Kammer (113A) erhitzt und veranlasst wird, dass die Flüssigkeit (112) durch einen Kanal (111) von der ersten Kammer (113A) in Richtung einer zweiten Kammer (113B) fließt und in thermischen Kontakt mit einer Wärmequelle (120) kommt, um Wärme von der Wärmequelle (120) zu absorbieren;
- Abschalten des am thermoelektrischen Kühler (111) anliegenden Stroms;
- Messen eines den vom thermoelektrischen Kühler erzeugten Strom anzeigenden Parameters; und
- Variieren einer Flussrate der Flüssigkeit (112) basierend auf der Messung des vom thermoelektrischen Kühler erhaltenen Parameters.

10. Verfahren nach Anspruch 9 ferner umfassend:
- Bewerten der Messung dieses Parameters im abgeschalteten Modus;
- Vergleichen des gemessenen Parameters mit einem vorgegebenen Wert oder einem vorbestimmten Wertebereich; und
- Bestimmen, ob der gemessene Parameter auf einen optimalen Betriebszustand hinweist.

11. Verfahren nach Anspruch 9 oder Anspruch 10, ferner umfassend das Bestimmung einer Polung des gemessenen Parameters zum Variieren der Flussrate der Flüssigkeit.

12. Verfahren nach Anspruch 11, umfassend das Variieren dieser Flussrate auf eine niedrigere Rate für eine erste Polung des gemessenen Parameters.

13. Verfahren nach Anspruch 12, umfassend das Variieren dieser Flussrate auf eine höhere Rate für eine zweite Polung des gemessenen Parameters entgegengesetzt zur ersten Polung.

14. Verfahren nach einem der vorstehenden Ansprüche 9 bis 13, umfassend:
- Anlegen einer ersten Polung des Stroms an den thermoelektrischen Kühler, damit die Flüssigkeit in der ersten Kammer erwärmt wird und durch den Kanal fließt;
- Anlegen einer zweiten Polung des Stroms an den thermoelektrischen Kühler, damit die Flüssigkeit in der zweiten Kammer erwärmt wird und durch den Kanal fließt;
wobei eine durch die erste Polung verursachte Strömungsrichtung der Flüssigkeit die gleiche ist wie die durch die zweite Polung verursachte Strömungsrichtung.

15. Verfahren nach einem der vorstehenden Ansprüche 9 bis 14, wobei der den Strom anzeigende Parameter eine Spannung ist, die zwischen zwei Punkten anliegt, wobei jeder Punkt auf einer jeweiligen Seite des thermoelektrischen Kühlers angeordnet ist; oder ein elektrischer Strom, der zwischen diesen beiden Punkten fließt.

## Revendications

1. Appareil comprenant :
- un refroidisseur thermoélectrique (111) ;
- un fluide (112) ;
- une première chambre (113A) et une seconde chambre (113B) reliées l'une à l'autre par un canal (140) ;
- le refroidisseur thermoélectrique étant conçu pour être alimenté en énergie électrique pour chauffer le fluide (112) dans la première chambre (113A) afin de faire s'écouler le fluide (112) à travers le canal (140), de la première chambre (113A) vers la seconde chambre (113B), et de le faire entrer en contact thermique avec une source de chaleur (120) pour absorber la chaleur provenant de la source de chaleur (120) ;
dans lequel, l'appareil comprend en outre un circuit de commande (170) conçu pour :
- couper l'alimentation en énergie électrique du refroidisseur thermoélectrique (111) ;
- mesurer un paramètre indiquant l'énergie électrique engendrée par le refroidisseur thermoélectrique (111) ; et
- faire varier un débit du fluide (112) en fonction de la mesure dudit paramètre, obtenue à partir du refroidisseur thermoélectrique (111).

2. Appareil selon la revendication 1, dans lequel le circuit de commande comprend des circuits conçus pour mesurer l'énergie engendrée par le refroidisseur thermoélectrique dans le mode hors tension, sur la base dudit paramètre.

3. Appareil selon la revendication 1 ou la revendication 2, dans lequel le circuit de commande comprend des circuits conçus pour évaluer la mesure dudit paramètre dans le mode hors tension et pour déterminer si le paramètre mesuré indique une condition optimale de fonctionnement en comparant le paramètre mesuré à une valeur prédéterminée ou à une plage prédéterminée de valeurs.

4. Appareil selon l'une quelconque des revendications précédentes, dans lequel le circuit de commande est conçu pour faire varier le débit du fluide en déterminant une polarité du paramètre mesuré.

5. Appareil selon la revendication 4, dans lequel le circuit de commande est conçu pour faire varier ledit débit à la baisse pour une première polarité du paramètre mesuré.

6. Appareil selon la revendication 5, dans lequel le circuit de commande est conçu pour faire varier ledit débit à la hausse pour une seconde polarité du paramètre mesuré, opposée à la première polarité.

7. Appareil selon l'une quelconque des revendications précédentes, dans lequel l'appareil est conçu pour :
- appliquer une première polarité d'énergie électrique au refroidisseur thermoélectrique pour chauffer ainsi le fluide dans la première chambre et le faire s'écouler à travers le canal ;
- appliquer une seconde polarité d'énergie électrique, opposée à la première polarité, au refroidisseur thermoélectrique pour chauffer ainsi le fluide dans la seconde chambre et le faire s'écouler dans le canal ;
dans lequel un sens d'écoulement du fluide causé par la première polarité est le même que le sens d'écoulement du fluide causé par la seconde polarité.

8. Appareil selon l'une quelconque des revendications précédentes, dans lequel le paramètre indiquant l'énergie électrique est une tension présente entre deux points, chaque point étant situé d'un côté respectif du refroidisseur thermoélectrique ; ou un courant électrique circulant entre lesdits deux points.

9. Procédé comprenant les étapes suivantes :
- alimenter un refroidisseur thermoélectrique (111) en énergie pour chauffer un fluide (112) dans une première chambre (113A) afin de faire s'écouler le fluide (112) à travers un canal (111), de la première chambre (113A) vers une seconde chambre (113B) et de le faire entrer en contact thermique avec une source de chaleur (120) pour absorber la chaleur provenant de la source de chaleur (120) ;
- couper l'alimentation en énergie électrique du refroidisseur thermoélectrique (111) ;
- mesurer un paramètre indiquant l'énergie électrique engendrée par le refroidisseur thermoélectrique ; et
- faire varier un débit du fluide (112) en fonction de la mesure dudit paramètre, obtenue à partir du refroidisseur thermoélectrique.

10. Procédé selon la revendication 9, comprenant en outre les étapes suivantes :
- évaluer la mesure dudit paramètre dans le mode hors tension ;
- comparer le paramètre mesuré à une valeur prédéterminée ou à une plage prédéterminée de valeurs ; et
- déterminer si le paramètre mesuré indique une condition optimale de fonctionnement.

11. Procédé selon la revendication 9 ou la revendication 10, comprenant en outre la détermination d'une polarité du paramètre mesuré pour faire varier le débit du fluide.

12. Procédé selon la revendication 11, comprenant le fait de faire varier ledit débit à la baisse pour une première polarité du paramètre mesuré.

13. Procédé selon la revendication 12, comprenant le fait de faire varier ledit débit à la hausse pour une seconde polarité du paramètre mesuré, opposée à la première polarité.

14. Procédé selon l'une quelconque des revendications 9 à 13 précédentes, comprenant les étapes suivantes :
- appliquer une première polarité d'énergie électrique au refroidisseur thermoélectrique pour chauffer ainsi le fluide dans la première chambre et le faire s'écouler à travers le canal ;
- appliquer une seconde polarité d'énergie électrique, opposée à la première polarité, au refroidisseur thermoélectrique pour chauffer ainsi le fluide dans la seconde chambre et le faire s'écouler à travers le canal ;
dans lequel un sens d'écoulement du fluide causé par la première polarité est le même que le sens d'écoulement du fluide causé par la seconde polarité.

15. Procédé selon l'une quelconque des revendications 9 à 14 précédentes, dans lequel le paramètre indiquant l'énergie électrique est une tension présente entre deux points, chaque point étant situé d'un côté respectif du refroidisseur thermoélectrique ; ou un courant électrique circulant entre lesdits deux points.
